Europäisches Patentamt

European Patent Office

Office européen des brevets

(19)

(11) Publication number: **0 426 246 A1**

# EUROPEAN PATENT APPLICATION

(12)

(21) Application number: **90202855.4**

(22) Date of filing: **29.10.90**

(51) Int. Cl.⁵: **H01L 23/485**, H01L 21/60, G02F 1/13

(30) Priority: **01.11.89 NL 8902695**

(43) Date of publication of application:
**08.05.91 Bulletin 91/19**

(84) Designated Contracting States:
**CH DE FR GB IT LI NL**

(71) Applicant: **N.V. Philips' Gloeilampenfabrieken**
**Groenewoudseweg 1**
**NL-5621 BA Eindhoven(NL)**

(72) Inventor: **Plangger, Guido**
**c/o INT. OCTROOIBUREAU B.V. Prof.**
**Holstlaan 6**
**NL-5656 AA Eindhoven(NL)**

(74) Representative: **Raap, Adriaan Yde et al**
**INTERNATIONAAL OCTROOIBUREAU B.V.**
**Prof. Holstlaan 6**
**NL-5656 AA Eindhoven(NL)**

(54) **Interconnection structure.**

(57) An interconnection structure (10) for pressure contacts, using the face-down bonding method, has a lower contact resistance by giving it a special profile, namely a raised edge (8) and by providing this edge with smooth spherical projections (7).

FIG.1

FIG.2

## INTERCONNECTION STRUCTURE

The invention relates to an interconnection structure for connecting a conductor pattern associated with a substrate in an electrically conducting manner.

The relevant conductor pattern may form part of, for example, a semiconductor substrate (integrated circuit or a discrete semiconductor element) or of a wiring pattern on, for example, glass, quartz, ceramic material, polyimide or synthetic resin.

The invention also relates to a display device in which such an interconnection structure is used.

An interconnection structure of the type described in the opening paragraph, also referred to as bump, may be provided on a semiconductor substrate for mounting by means of the so-called flip-chip method (also referred to as face-down bonding). Such a structure is described in USP 4,749,120. An IC provided with such bumps is mounted on a glass substrate by means of said flip-chip method. In one of the mounting methods described in USP 4,749,120 an electrically conducting contact is obtained between the bump and the conductor track by means of a pressure contact, whereafter the pressure of this contact is maintained by curing a resin layer provided between the substrate and the IC.

Such a mounting method is used, inter alia , in the manufacture of display devices (LCDs) in which ICs are secured by means of said flip-chip method on a substrate of glass or quartz which also forms part of the actual (liquid crystal) display device. Conductor tracks continuing as far as the actual display section are provided with drive voltages via the integrated circuits which contact these conductor tracks by means of said interconnection structures (or bumps).

However, a number of problems may occur. A first problem occurs, for example, when contacting integrated circuits with many bumps, where different types of conductor tracks are present on the substrate, for example, indium tin oxide tracks for driving pixels in addition to, for example, aluminium tracks. A possible difference in thickness between the different types of conductor tracks may give rise to poor or open contacts, notably in the case of pressure contacts.

Moreover, if no special measures are taken, the actual scontact of the interconnection structure with, for example, a thin connection conductor may remain limited to a very small area (for example, a projecting point of the bump), which leads to a high contact resistance. The latter notably occurs if a small pressure is used for contacting, for example, for test purposes.

The present invention has for its object to eliminate the above-mentioned drawbacks as much as possible.

It is based, inter alia , on the recognition that the contact resistance is decreased and that simultaneously the reliability of the interconnection structure can be enhanced by giving it a special profile.

To this end an interconnection structure according to the invention is characterized in that it has its largest height along its circumference and in that its surface area in the central portion is substantially flat. The surface area of the interconnection structure may be substantially smooth or provided with spherical projections at the area of its circumference.

Spherical projections, which are preferably smooth, are herein understood to mean, for example, approximately ball-shaped projections. By manufacturing the interconnection structure of, for example, gold, it is subjected to such a plastic deformation already at a low pressure ·that differences in the distance between the integrated circuit and the conductor tracks on the substrate are compensated for. The material of, for example, the interconnection structure and the conductor track to be contacted on the substrate can be chosen in such a way (for example, gold and indium tin oxide, respectively) that temperature changes hardly influence the reliability of the pressure contact.

An advantage of the raised circumference (with respect to the central portion) is that satisfactory electric contacts are obtained at the area of the circumference (either or not via possible projections), so that the above mentioned current concentration at one point is avoided and particularly the leakage resistance in thin layers is reduced. This advantage is notably achieved if the interconnection structure, in a plan view, is circular, but good results are also achieved with regular or irregular polygons. In a plan view, the interconnection may be, for example, star-shaped. Notably, narrow raised strips are then obtained along the edge, which strips are wellresistant to the plastic deformation, while the surface area in the central portion remains substantially smooth so that test pins for testing an integrated circuit establish a satisfactory contact therewith (without a high series resistance).

The thickness of the central portion is approximately 1-3 $\mu$m, while the radii of curvature of the projections on the raised circumference are approximately 1-3 $\mu$m.

Viewed in cross-section, the maximum height is preferably 10 $\mu$m.

The interconnection structure according to the invention is particularly suitable for substrates having connections arranged in a plurality of rows, as described in Netherlands Patent Application no. 8900675 (PHQ 89005) in the name of the Applicant.

The interconnection structure is notably advantageous in a display device in which connection electrodes extending beyond the display device on a (glass) supporting body are contacted, for example, with an integrated circuit for drive purposes.

The invention will now be described in greater detail with reference to an embodiment and the accompanying drawing in which

Fig. 1 is a diagrammatic plan view of an interconnection structure according to the invention;

Fig. 2 is a diagrammatic cross-section taken on the line II-II in Fig. 1;

Fig. 3 shows diagrammatically a device in which interconnection structures according to the invention are used.

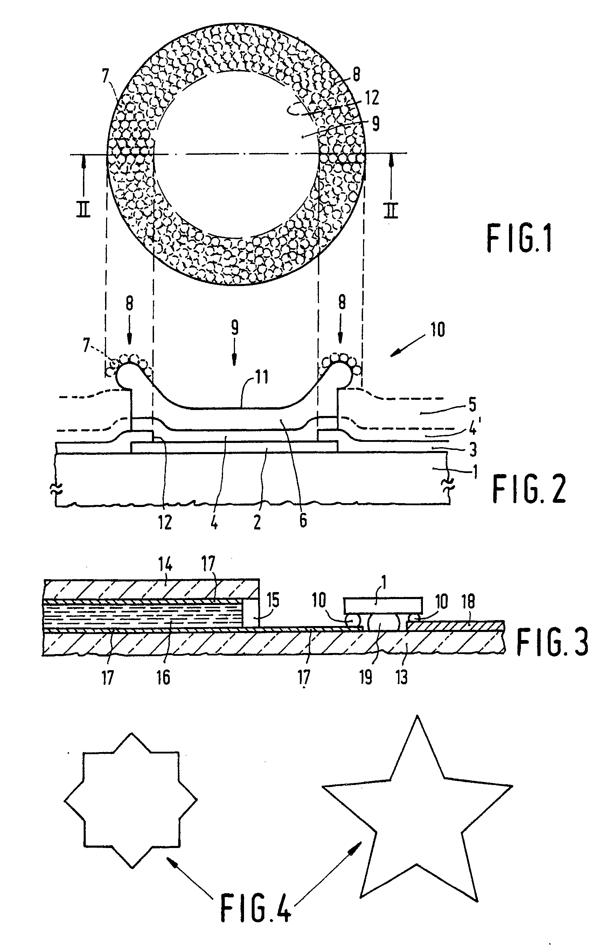

The interconnection structure (bump) 10 of Fig. 1, 2 is present on a substrate 1, in this example an integrated circuit formed in silicon. The wiring pattern of the integrated circuit comprises, inter alia , bonding pads 2 for contacting the circuit. The silicon substrate 1 has a passivating layer 3 of silicon oxide, silicon nitride or a combination thereof, which covers the entire surface of the substrate 1, with the exception of the bonding pads 2. The passivating layer 3 has a thickness of approximately 1 $\mu$m and at the area of the bonding pads 2 it is provided with windows 12 having a slightly smaller surface area. In this example the bonding pads 2 are circular and have a diameter of approximately 70 $\mu$m, while the windows 12 have a diameter of approximately 40 $\mu$m.

The interconnection pattern has a double layer which comprises a first layer 4 of aluminium and a second layer 6 of gold with a total thickness of 3-6 $\mu$m in this example. The thickness of the layer 4 is approximately 1 $\mu$m, while the thickness of the layer 6 is 2 $\mu$m in the central portion and approximately 5 $\mu$m along the edges. The gold layer 6 has a substantially smooth surface area 11 at the area of the central portion 9. The edge 8 which is raised with respect to the central portion 9 has a substantially smooth surface area but it may also be provided with small ball-shaped projections 7 which have dimensions of 1-3 $\mu$m (illustrated by means of broken lines in Figs. 1, 2).

The interconnection structure (bump) 10 described above can be manufactured as follows.

The method starts from a substrate 1 comprising an (integrated) circuit or other switching element having bonding pads 2 and being coated with a passivating layer 3 having windows 12 at the area of the bonding pads. Firstly, a layer of aluminium 4 with a thickness of 1 $\mu$m is deposited on the whole assembly, which layer is used as a short-circuit layer at a later stage for obtaining the further structure by electrodeposition. The layer 4 may have an antidiffusion coating to prevent gold from diffusing into the aluminium, if gold is used for the layer 6.

Subsequently, a mask 5 of a photoresist is provided photolithographically, which defines the areas where electrodeposition can take place. This layer has a thickness of, for example, 3 $\mu$m, while the apertures in the mask 5 at the area of the bonding pads 2 have a diameter of approximately 60 $\mu$m.

Electrodeposition is performed in three steps. Firstly, a thin metal layer (in this example gold) is deposited to a thickness of approximately 1 $\mu$m at a low electrodeposition current (pulsed or not pulsed) at a temperature of approximately 45°C. The layer thus obtained is in compliance with the underlying profile and is substantially smooth and flat. Subsequently, electrodeposition is continued with high currents. The current density then is 300-600 $mA/cm^2$ (related to the effective surface area of the bumps). During electrodeposition the circulation in the electrodeposition bath is interrupted. Due to the locally prevailing high electric field strengths, the gold layer is then deposited substantially along the edge of the openings in the mask 5. This results in a narrow raised edge having a given roughness, and the gold thus deposited is fairly hard.

Finally, a thin gold layer of approximately 1 $\mu$m is electrodeposited, which layer is comparatively soft and is deposited to a stronger degree on the edge so that the raised edge may obtain a smooth surface. After electrodeposition the layers 5 and 4' are removed.

An interconnection pattern according to Figs. 1, 2 having an edge 8 which is raised with respect to the flat central portion 9, which edge 8 may be provided with smooth spherical projections 7, is obtained in this manner, presumably by a combination of local field variations and the originally provided contours. As is apparent from Fig. 2, the edge 8 may be bent back to some extent. Since the above-mentioned third layer having a thickness of approximately 1 $\mu$m is soft, the bump 10 is notably suitable as a pressure contact.

Fig. 3 shows a substrate 1 with, for example, a control circuit which establishes an electrically conducting contact with conductor tracks 17, 18 on a supporting body 13 of, for example, glass (or quartz) via such interconnection structures 10 and by means of pressure contacts. Together with a sealing edge 15, the glass plate 13 and a second glass plate 14 jointly enclose a liquid crystal material 16 and thus form a part of a liquid crystal display device. (Further components such as polarizers, lighting elements, etc. have been omitted for the sake of simplicity in Fig. 3).

To be able to drive the display device, it has connection electrodes which are formed by conductor tracks 17 of, for example, indium tin oxide, which tracks extend beyond the edge 15 in this example and are connected in an electrically conducting manner to the control circuit in the substrate 1 via interconnection structures (bumps) 10. External signals are applied to this control circuit via aluminium tracks 18 and interconnection structures (bumps) 10. A possible difference in thickness between the conductor tracks 17 and 18 (exaggerated in Fig. 3) is compensated for, because the bumps 10 can be depressed over a large part of their thickness without any influence on sthe electric contact. The pressure for these pressure contacts is maintained in the relevant example by means of an adhesive bond 19.

The invention is of course not limited to the embodiment shown, but several variations are possible within the scope of the invention. For example, the bumps 10 may also be formed on the supporting body. Moreover, the interconnection structures need not necessarily be circular or, for example, hexagonal or octagonal, but the described structure may alternatively be obtained with the more conventional square shape. Notably, star-shaped structures (shown by way of example in Fig. 4) may be advantageous; due to the very high field strengths at the corners (during electrodeposition) a crown of raised portions may be produced around a central portion which remains smooth and is therefore suitable for testing by means of test pins.

The passivating layer 3 may also have a larger thickness, for example, if it is formed in polyimide. Moreover, variations of the layer structure 4, 6 (for example, copper with a gold coating) are possible.

Various other applications are also possible. For example, in Fig. 3 the liquid crystal may be replaced by other electrooptical media such as electrochromic or electrophoretic materials.

More generally, the invention is applicable to chip-on-glass techniques, for example, for memories or to face-down bonding techniques on ceramic material, polyimide, etc.

Interconnection structures according to the invention may also be used advantageously in control circuits for thin display devices as described in NL 8700486 (PIN 12.047).

height along its circumference and in that its surface area in sthe central portion is substantially flat.

2. An interconnection structure as claimed in Claim 1, characterized in that the surface area is substantially smooth at the area of its circumference.

3. An interconnection structure as claimed in Claim 1, characterized in that the surface area is provided with spherical projections at the area of its circumference.

4. An interconnection structure as claimed in Claim 1, 2 or 3, characterized in that the maximum height, viewed in cross-section, is 10 $\mu$m.

5. An interconnection structure as claimed in any one of Claims 1 to 4, characterized in that the thickness of the central portion is 1-3 $\mu$m.

6. An interconnection structure as claimed in any one of the preceding Claims, characterized in that the radii of curvature of the spherical projections are 1-3 $\mu$m.

7. An interconnection structure as claimed in any one of Claims 1 to 6, characterized in that, in a plan view, said structure is substantially circular, square, hexagonal, octagonal or star-shaped.

8. An interconnection structure as claimed in Claim 7, characterized in that the diameter of the interconnection structure is at most 100 $\mu$m.

9. An interconnection structure as claimed in any one of the preceding Claims, characterized in that the substrate is a semiconductor body, glass, quartz, synthetic resin, polyimide or a ceramic material.

10. A display device comprising an electro-optical medium between two supporting bodies provided with drive electrodes, which drive electrodes on one of the supporting bodies extend as far as beyond the surface area determined by the electro-optical medium, characterized in that the drive electrodes are connected in an electrically conducting manner to a semiconductor substrate by means of an interconnection structure as claimed in any one of Claims 1 to 9.

11. A display device as claimed in Claim 10, characterized in that the semiconductor substrate comprises a control circuit for the display device.

12. A display device as claimed in Claim 10 or 11, characterized in that the electro-optical medium is a liquid crystal.

## Claims

1. An interconnection structure for connecting a conductor pattern associated with a substrate in an electrically conducting manner, characterized in that the interconnection structure has its largest

**FIG.1**

**FIG.2**

**FIG.3**

**FIG.4**

European
Patent Office

EUROPEAN SEARCH
REPORT

Application Number

EP 90 20 2855

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 332 402 (SHARP)<br>* Figure 5; claim 2; column 2, line 50 - column 3, line 7 *<br>— — — | 1,2 | H 01<br>L 23/485<br>H 01 L 21/60 |
| A | | 9-12 | G 02 F 1/13 |
| X | WO-A-8 502 715 (HONEYWELL)<br>* Figures 1,2 *<br>— — — | 1,2 | |
| A | GB-A-2 184 288 (NAT. SEMIC.)<br>* Claims 8,9 *<br>— — — | 3 | |
| A | EP-A-0 271 110 (TOSHIBA)<br>* Claim 12 *<br>— — — | 5 | |
| A | EP-A-0 313 082 (TOSHIBA)<br>* Claim 2 *<br>— — — | 8 | |
| A | IBM TECHNICAL DISCLOSURE BULLETIN, vol. 11, no. 10, March 1969, page 1339, New York, US; N.G. AINSLIE et al.: "Via hole for pad connection"<br>— — — | 7 | |
| A | PATENT ABSTRACTS OF JAPAN, vol. 9, no. 118 (E-316)[1841], 23rd May 1985;<br>& JP-A-60 7757 (NIPPON DENKI) 16-01-1985<br>— — — | 7 | TECHNICAL FIELDS SEARCHED (Int. Cl.5)<br><br>H 01 L<br>G 02<br>F |
| A | EP-A-0 177 251 (NEC)<br>— — — — — | | |

The present search report has been drawn up for all claims

| Place of search | Date of completion of search | Examiner |
|---|---|---|
| The Hague | 14 September 91 | DE RAEVE R.A.L. |